# EUROPEAN PATENT SPECIFICATION

(11) **EP 2 667 408 B1**
(45) Date of publication and mention of the grant of the patent: **10.04.2019**
(21) Application number: 12183408.9
(22) Date of filing: 07.09.2012
(51) Int. Cl.: H01L 23/427, H05K 7/20, F28D 15/02

(54) **NATURAL CIRCULATION TYPE COOLING APPARATUS**
KÜHLVORRICHTUNG MIT NATÜRLICHER ZIRKULATION
APPAREIL DE REFROIDISSEMENT DE TYPE CIRCULATION NATURELLE

(30) Priority: 23.05.2012 JP 2012117812
(43) Date of publication of application: 27.11.2013
(73) Proprietor: Kabushiki Kaisha Toshiba, Minato-ku, Tokyo 105-8001 (JP)
(72) Inventor: Tsukinari, Yuuki, Tokyo, 105-8001 (JP); Koyama, Taihei, Tokyo, 105-8001 (JP); Abe, Satoru, Tokyo, 105-8001 (JP); Ishii, Hiroshi, Tokyo, 105-8001 (JP); Kurosawa, Satoshi, Tokyo, 105-8001 (JP); Sekimoto, Akio, Tokyo, 105-8001 (JP)
(74) Representative: AWA Sweden AB

(56) References cited:
- WO-A1-2006/072244
- WO-A2-2005/055319
- JP-A- H11 193 980
- US-A1- 2009 080 155

## Description

### FIELD

Embodiments described herein relate generally to a cooling apparatus applied with a natural circulation liquid cooling method, in which a coolant circulation pump for providing an external driving force is not used, and which cools an exothermic body such as a semiconductor device that is used in a power converter for a railway vehicle.

### BACKGROUND

In general, a power converter for a railway vehicle comprises an exothermic body such as a semiconductor device, and a cooling apparatus for cooling such an exothermic body. As a cooling method of a large-capacity cooling apparatus, a boiling cooling method and a forced circulation liquid cooling method are applied. In a cooling apparatus to which the former cooling method is applied, there are, because of the device structure, such restrictions on disposition that a high-temperature unit is disposed on a lower side and a low-temperature unit is disposed on an upper side. In addition, it is the fact that there is an international trend toward complete disuse of a Freon-based coolant which is used for this cooling method. On the other hand, in a cooling apparatus to which the latter cooling method is applied, there are many structural elements which accompany the cooling system, such as a circulation pump, conduits, a fluid reservoir tank, a heat exchanger, etc., and there are demerits such as an increase in volume for installation and an increase in cost due to this.

In recent years, there has been proposed a technique for a cooling method, in which the demerits of both of the above-described cooling methods are eliminated. In this technique, a coolant is naturally circulated in the system. Specifically, buoyancy of boiling bubbles, which are generated by the exothermic body, such as a semiconductor device, is used as a circulation driving force. According to this natural circulation cooling method, a passive cooling system, which uses no external driving force, can be constructed.

JP H11 193980 A is considered to be the closest prior art and discloses a heat drive type cooler formed of a circulating pipeline of a sealed structure, comprising a hear receiver, a discharge tube, a liquid flow tube, a vapor-liquid separator, a liquid phase radiator, a vapor phase radiator and a gas flow tube.

WO 2005/055319 A2 discloses a system for cooling comprising a first heat-receiving part, a cooling fluid, a bubble pump, and a condenser.

WO 2006/072244 A1 discloses a multi-orientational cooling system with a bubble pump for generation of a circulating flow of cooling fluid comprising at least one hollow member comprising a first heat-receiving part, a heat-emitting part, and a tubular first part, and a tubular second part.

In a cooling apparatus using the above-described natural circulation cooling method, a heat exchanger for condensing a generated vapor is disposed on an upper side of a heat receiver to which the exothermic body is attached, and a radiator is disposed on a lateral side of the heat receiver. In the case of this structure, because of the positional configuration within the power converter, there are cases where the direction of disposition of the cooling apparatus is restricted due to problems with the space occupied by the apparatus, the equipment size, and the mounting of the apparatus. Hence, the degree of freedom of design of the entire apparatus system decreases.

### BRIEF DESCRIPTION OF THE DRAWINGS

FIG. 1 is a side view which schematically illustrates a railway vehicle including a natural circulation type cooling apparatus according to a first embodiment;
FIG. 2 is a plan view which schematically illustrates an underflow side of the railway vehicle;
FIG. 3 is a front view which schematically illustrates the cooling apparatus according to the first embodiment;
FIG. 4 is a partially cutaway perspective view of a heat receiver of the cooling apparatus;
FIG. 5 is a cross-sectional view of the heat receiver, taken along line A-A in FIG. 4;
FIG. 6 is a cross-sectional view of the heat receiver, taken along line B-B in FIG. 4;
FIG. 7 is a front view which schematically illustrates a natural circulation type cooling apparatus according to a second embodiment;
FIG. 8 is a side view which schematically illustrates a natural circulation type cooling apparatus according to a third embodiment;
FIG. 9 is a cross-sectional view showing an internal structure in an upper part of a heat receiver of the cooling apparatus according to the third embodiment;
FIG. 10 is a side view which schematically illustrates a natural circulation type cooling apparatus according to a fourth embodiment;
FIG. 11 is a side view which schematically illustrates a natural circulation type cooling apparatus according to a fifth embodiment;
FIG. 12 is a side view which schematically illustrates a natural circulation type cooling apparatus according to a sixth embodiment; and
FIG. 13 is a side view which schematically illustrates a natural circulation type cooling apparatus according to a seventh embodiment.

### DETAILED DESCRIPTION

Various embodiments will be described hereinafter with reference to the accompanying drawings. In general, according to one embodiment, a natural circulation type cooling apparatus comprises: a heat receiver comprising a heat receiving surface on which an exothermic body is mounted, and containing therein a coolant in a liquid phase; a condenser provided on a horizontally lateral side of the heat receiver, and configured to condense a vapor which is generated by the heat receiver; a radiator disposed on a horizontally lateral side of the heat receiver and on a vertically downward side of the condenser, and configured to cool the coolant which is fed from the heat receiver and is heated; a vapor conduit configured to feed the vapor of the coolant, which is generated by the heat receiver, to an inlet of the condenser; a condensed liquid conduit configured to feed the coolant, which is condensed, from an outlet of the condenser to a coolant inlet of the heat receiver; a coolant conduit configured to feed the coolant, which is heated in the heat receiver, to an inlet of the radiator; and a coolant circulation conduit configured to feed the coolant, which is cooled in the radiator, from an outlet of the radiator to the coolant inlet of the heat receiver.

### (First Embodiment)

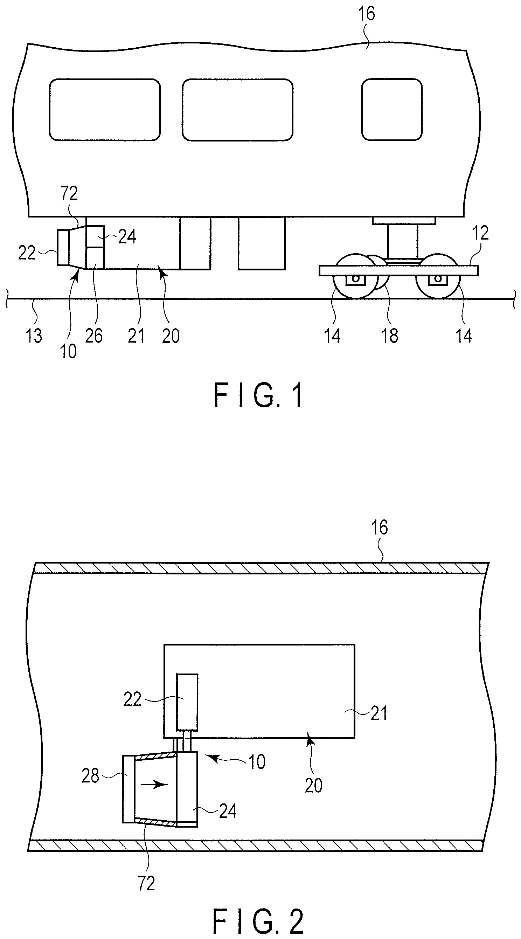

FIG. 1 and FIG. 2 are, respectively, a side view and a plan view which schematically illustrate a railway vehicle including a natural circulation type cooling apparatus according to a first embodiment. The railway vehicle comprises a truck 12 provided with wheels 14, and a vehicle body 16 supported on the truck 12. A traction motor 18 is mounted on the truck 12 in the vicinity of the wheels 14. The traction motor 18 transmits a torque to the wheels 14 via a gear box and a coupling, which are not shown. The wheels 14 are placed on rails 13. Various devices including a power converter 20 are equipped under the floor of the vehicle body 16. A natural circulation type cooling apparatus 10 according to the embodiment is configured, for example, as a cooling apparatus for cooling semiconductor devices (exothermic body) which constitute the power converter 20, and is disposed under the floor of the vehicle body 16.

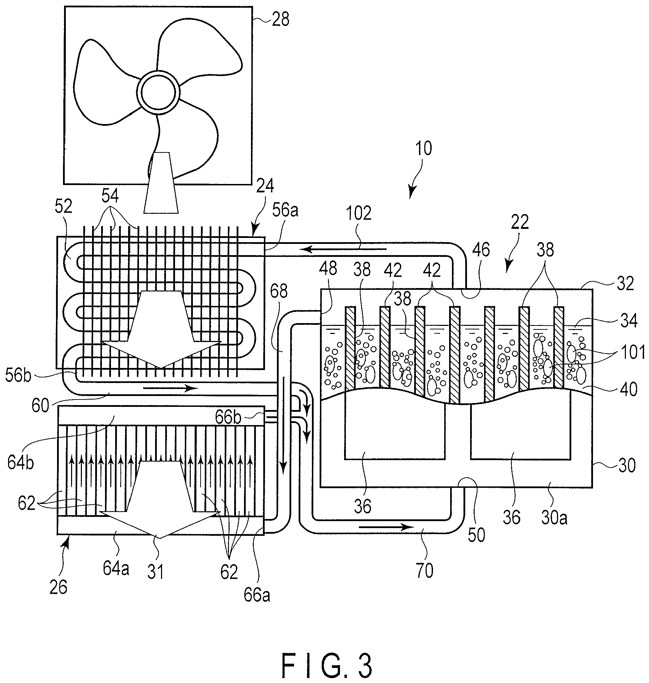

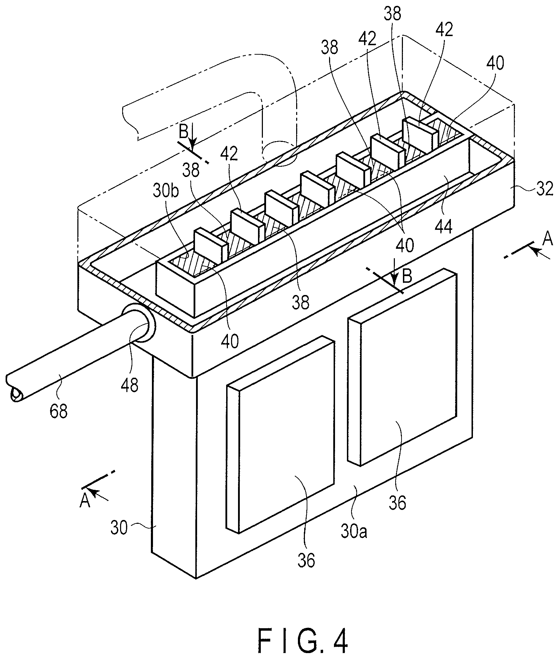

FIG. 3 is a front view schematically showing the structure of the entirety of the cooling apparatus 10. FIG. 4, FIG. 5 and FIG. 6 are, respectively, a perspective view and cross-sectional views showing a heat receiver of the cooling apparatus 10. As shown in FIG. 1 to FIG. 3, the cooling apparatus 10 comprises a heat receiver 22 which cools semiconductor devices by receiving heat from the semiconductor devices, a condenser 24, a radiator 26, and a plurality of conduits which interconnect these components. In the embodiment, the cooling apparatus 10 further comprises an air blower 28.

The heat receiver 22 is provided, for example, within a housing 21 of the power converter 20, and is positioned in a substantially vertical plane. The condenser 24 and radiator 26 are arranged in the vertical plane common with the heat receiver 22, or in another vertical plane parallel to this vertical plane. The condenser 24 is provided on a horizontally lateral side of the heat receiver 22. The radiator 26 is arranged on the horizontally lateral side of the heat receiver 22, and on a vertically downward side of the condenser 24. The air blower 28 is opposed to the rear side of the condenser 24 and radiator 26.

As shown in FIG. 3 to FIG. 6, the heat receiver 22 includes a container body 30 having an elongated rectangular box shape, and an upper container 32 of a rectangular box shape, which covers an upper part of the container body 30 and forms a sub-flow passage which will be described later. One or both of major surfaces of the container body 30 constitute a heat receiving surface 30a. A plurality of semiconductor devices 36, for example, two semiconductor devices 36, which are exothermic bodies, are mounted on the heat receiving surface 30a. The semiconductor devices 36 constitute a part of the power converter 20.

The container body 30 is formed in a predetermined size in accordance with the cooling capability of the cooling apparatus, and a predetermined amount of liquid-phase coolant 34 is sealed in the container body 30. As the coolant 34, use is made of pure water, a hydrocarbon-based coolant, an ammonia aqueous solution, an antifreeze liquid (ethylene glycol aqueous solution, propylene glycol aqueous solution, etc.), or a heat-accumulation microcapsule. In general, a chemically stable coolant is used, and the coolant preferably has thermophysical properties of high evaporation latent heat and thermal conductivity, and a low viscosity coefficient.

As the material for forming the heat receiving surface 30a of the heat receiver 22, aluminum or brass is used in accordance with the coolant that is applied. In addition, it is possible to apply a material in which heat transfer is promoted by reforming the heat receiving surface 30a with an external physical treatment such as beam irradiation or flame spray coat shaping.

A plurality of partition plates 38 are provided in the container body 30 of the heat receiver 22, so as to form desired flow passages or containing chambers. The partition plates 38 are arranged in the vertical direction within the container body 30, and at predetermined intervals in the horizontal direction. Containing chambers 40 which contain the coolant 34, or passages, are formed between mutually neighboring partition plates 38 or between the partition plates and side walls of the container body 30. A lower end of each partition plate 38 is slightly spaced apart from a bottom wall of the container body 30, and thereby the plural containing chambers 40 communicate with each other in the lower part within the container body 30.

In addition, an upper end portion of each partition plate 38 extends upward, beyond an upper opening 30b of the container body 30, and is located within the upper container 32. The upper end portions of the partition plates 38 form baffle pates 42. The baffle plates 42 restrain the coolant 34, which flows out of each containing chamber 40 of the container body 30, from flowing into the neighboring containing chambers 40. In the meantime, the structure of the baffle plate 42 is not limited to the structure in which the baffle plate 42 is formed integral with the partition plate 38. The baffle plate 42 may be configured such that a separately formed baffle plate is fixed to the partition plate 38.

By the upper container 32, a sub-flow passage 44 is formed around the upper opening 30b of the container body 30. The coolant 34, which is heated and flows out of each containing chamber 40, flows into the sub-flow passage 44, and is fed to a coolant outlet (to be described later) through the sub-flow passage 44. The sub-flow passage 44 may be configured to be inclined at a desired angle to the coolant outlet side, so that the coolant may efficiently be fed to the coolant outlet.

A vapor exhaust port 46 is formed in a ceiling wall of the upper container 32, and this vapor exhaust port 46 communicates with the plural containing chambers 40 via a space within the upper container 32. A coolant outlet 48 is formed in a side wall of the upper container 32, and this coolant outlet 48 communicates with the sub-flow passage 44. A coolant inlet 50 is formed in a bottom wall of the container body 30, and this coolant inlet 50 communicates with the plural containing chambers 40.

As shown in FIG. 3, the condenser 24 includes a conduit 52 which extends in a bellows shape and flows vapor, and a plurality of radiation fins 54 which are disposed directly or indirectly on the periphery of the conduit 52. The conduit 52 includes an inlet 56a which is located at one end of the conduit 52, and an outlet 56b which is located at the other end of the conduit 52. The outlet 56b is located on a vertically downward side of the inlet 56a.

The inlet 56a of the conduit 52 is connected to the vapor exhaust port 46 of the heat receiver 22 via a vapor conduit 58. The outlet 56b of the conduit 52 is directly connected to the coolant inlet 50 of the heat receiver 22 via a condensed liquid conduit 60, or is connected to the coolant inlet 50 via a coolant circulation conduit 70 (to be described later). The condenser 24 cools the vapor which flows in the conduit 52, condenses the vapor into a coolant liquid, and discharges the coolant liquid from the outlet 56b to the condensed liquid conduit 60. The discharged coolant liquid is returned to the heat receiver 22 through the condensed liquid conduit 60.

The condenser 24 may be configured or shaped such that the inside of the condenser 24 is coated with a paint with high water repellency in order to promote heat transfer with condensation, and an inclination is provided make it easier for the generated condensed liquid to flow downward.

As shown in FIG. 3 and FIG. 4, the radiator 26 includes a plurality of radiation tubes 62 which extend in the vertical direction and are juxtaposed in the horizontal direction, an inflow portion 64a which communicates with lower ends of the radiation tubes 62, an outflow portion 64b which communicates with upper ends of the radiation tubes 62, an inlet 66a which is provided at the inflow portion 64a, and an outlet 66b which is provided at the outflow portion 64b. Radiation fins may be provided on peripheries of the radiation tubes 62.

The inlet 66a of the inflow portion 64a is connected to the coolant outlet 48 of the heat receiver 22 via a coolant conduit 68. The inlet 66a is located on a vertically downward side of the coolant outlet 48 of the heat receiver 22. The outlet 66b of the outflow portion 46b is connected to the coolant inlet 50 of the heat receiver 22 via the coolant circulation conduit 70.

If a high-temperature coolant is fed from the heat receiver 22 to the radiator 26 via the coolant conduit 68, the radiator 26 flows the coolant upward from the inflow portion 64a through the plural radiation tubes 62 and, during this time, releases the heat of the coolant to the outside air and cools the coolant via the radiation tubes. Further, the radiator 26 feeds out the cooled coolant to the coolant circulation conduit 70 via the outflow portion 64b. The discharged coolant is returned to the heat receiver 22 through the coolant circulation conduit 70. In the present embodiment, the condensed liquid conduit 60 is connected to an intermediate portion of the coolant circulation conduit 70. Thereby, the coolant liquid, which has been discharged from the condenser 24, is fed to the heat receiver 22 via the condensed liquid conduit 60 and coolant circulation conduit 70.

As shown in FIG. 1 to FIG. 3, the air blower 28 is disposed to be opposed to the rear side of the condenser 24 and radiator 26, and the air blower 28 may be configured to be directly attached to the condenser 24 and radiator 26, or may be configured to be connected to the condenser 24 and radiator 26 via an air duct 72. The air blower 28 feeds a cooling wind to the condenser 24 and radiator 26, and facilitates cooling of the condenser 24 and radiator 26. When the air duct 72 is disposed, the amount of air of the air blower 28 can be increased. In addition the condenser 24 and radiator 26 may be configured to be disposed in a manner to protrude to the outside of the vehicle body, thereby to make use of a traveling wind, which is caused by traveling, as a cooling wind.

The cooling operation of the cooling apparatus 10 having the above-described structure is described.

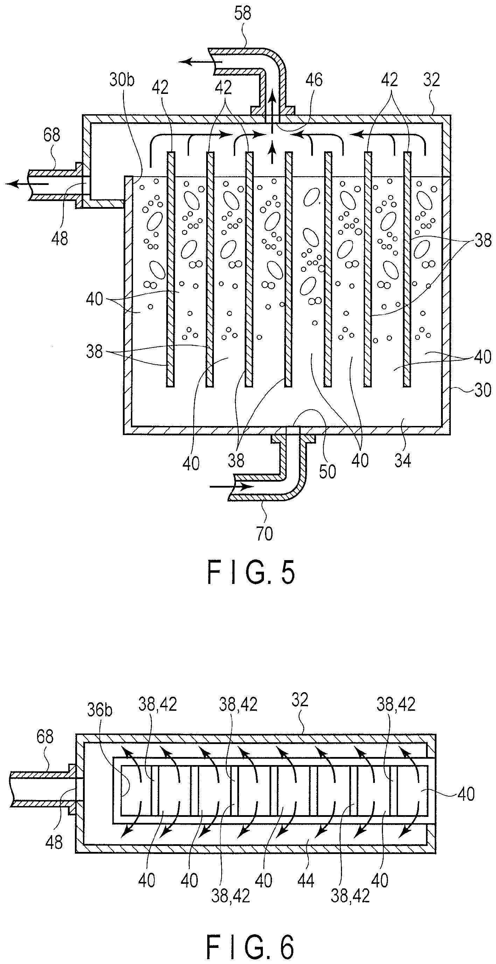

As shown in FIG. 3 and FIG. 5, when the semiconductor devices 36 mounted on the heat receiving surface 30a of the heat receiver 22 are activated and produce heat, the heat conducts through the heat receiving surface 30a and heats, by heat transfer, the coolant 34 that is sealed in the container body 30 of the heat receiver 22. As the amount of loss in the semiconductor devices 36 increases, the coolant 34 reaches a saturation temperature and starts boiling. Bubbles 101, which are generated by boiling, produce a driving force by a difference in density from an ambient liquid. Specifically, buoyancy by the bubbles 101 generates an upward stream in the container body 30. With the bubbles 101 rising, the ambient coolant 34 also rises accordingly. In the upper part of the container body 30, the coolant 34 has a mixed phase of a gas phase and a liquid phase, that is, a gas/liquid two-phase fluid state.

On the other hand, a vapor 102, which is generated by the heat receiver 22, is fed to the condenser 24 via the vapor conduit 58. In the condenser 24, heat exchange is performed by the radiation fins 54 that are disposed on the periphery thereof, and the vapor 102 is condensed into liquid. The condensed liquid of coolant is fed to the lower part of the heat receiver 22 via the condensed liquid conduit 60 and coolant circulation conduit 70.

As shown in FIG. 4 and FIG. 6, at the same time, the high-temperature, gas/liquid two-phase coolant 34 at the upper part of the heat receiver 22 flows out of the upper opening 30b of the container body 30, with the upward stream thereof becoming a circulation driving stream. The outflow coolant 34 is guided to the sub-flow passage 44, and is further fed to the inflow portion 64a of the radiator 26 from the sub-flow passage 44 via the coolant conduit 68. At this time, the baffle plates 42, which are provided at the upper part of the container body 30, prevent the high-temperature coolant from flowing back into the heat receiver, that is, from flowing back into the neighboring containing chamber 40. Thereby, the coolant, which flows out of the heat receiver 22, can efficiently be fed to the coolant conduit 68 via the sub-flow passage 44.

As shown in FIG. 3, the high-temperature coolant 34, which has flowed in the radiator 26, flows upward through the radiation tubes 62 and is fed to the outflow portion 64b, and, during this time, the heat is dissipated and the coolant 34 is cooled. The temperature of the coolant, which flows in from the lower part of the radiator 26, is high, and the temperature of the upper part within the radiator 26 is relatively low. Thus, by convection due to a difference in density, a heat current moves from the lower part to the upper part within the radiation tubes 62 of the radiator 26, and the coolant also flows upward. The cooled coolant is fed out to the coolant circulation conduit 70 from the outflow portion 64b, and is fed to the heat receiver 22 via the coolant circulation conduit 70.

The condenser 24 and radiator 26 are forcibly air-cooled as one body by cooling air 31 from the air blower 28 which is disposed outside. In this manner, in the cooling apparatus 10, a natural circulation stream is induced by the circulation loop structure, without external driving. As has been described above, the heat of the semiconductor devices 36 is absorbed by the heat receiver 22 and coolant 34, and the semiconductor devices 36 are cooled.

According to the natural circulation type cooling apparatus 10 with the above-described structure, the heat produced from the semiconductor devices 36, which are attached to the heat receiving surface 30a of the heat receiver 22, is transferred to the coolant 34 within the heat receiver 22 by heat conduction and heat transfer. When the coolant 34 in the heat receiver 22 has reached a predetermined saturation temperature due to an increase of loss in the semiconductor devices 36, the coolant 34 starts boiling. At this time, since the evaporation latent heat, that is, the latent heat that is removed when the coolant evaporates, is remarkably higher than in the case of usual sensible heat transfer, high-level heat transfer can be performed. By the effect of buoyancy of bubbles 101 which are generated by the boiling, an upward stream occurs and a circulation stream is induced within the apparatus. The generated vapor 102 is fed to the condenser 24 via the vapor conduit 58, and is condensed. Thereby, it is possible to suppress an increase in pressure within the apparatus due to the generation of vapor, and an increase in saturation temperature value of the coolant 34 due to the increase in pressure, and to maintain a circulation stream of coolant at a desired temperature level.

The inside of the cooling apparatus is kept in a reduced-pressure sealed state, the saturation temperature value of the coolant 34 is lowered, and boiling is started earlier. Thereby, it is possible to satisfy a tolerable temperature or below of the semiconductor devices 36. Furthermore, the coolant 34, which has been fed out via the coolant conduit 68, is subjected to heat exchange by the radiator 26, is reduced in temperature, and is circulated once again into the heat receiver 22 in a state in which the coolant 34 has a desired subcool degree. Thus, it is also possible to suppress burn-out on the heat conduction surface within the heat receiver 22, and to increase a heat-removal limit value. Thereby, the cooling apparatus can exhibit a good radiation capability.

By disposing the condenser and radiator on the horizontally lateral side of the heat receiver 22, it is possible to relax restrictions on disposition of the cooling apparatus and to reduce the size of the cooling apparatus. The inflow portion of the condenser 24 is in a high-temperature state due to the vapor. Conversely, the outflow portion of the condenser 24 communicates with the coolant circulation conduit through which the coolant cooled by the radiator 26 flows. Hence, a pressure difference tends to easily occur between the inlet and outlet of the condenser 24, the amount of inflow vapor to the condenser can be increased, the coolant can efficiently be condensed and circulated, and the cooling capability can be enhanced. When the flow amount of coolant is small, the heat transfer is promoted within the radiator, and the circulation of coolant can be stabilized.

From the above, there can be obtained a natural circulation type cooling apparatus, which can relax restrictions on disposition and realize reduction in size, and can exhibit a good heat radiation capability.

Next, natural circulation type cooling apparatuses according to other embodiments will be described.

In the embodiments to be described below, the structural parts, which are identical or equivalent to those in the above-described first embodiment, are denoted by like reference numerals, and a detailed description is omitted.

### (Second Embodiment)

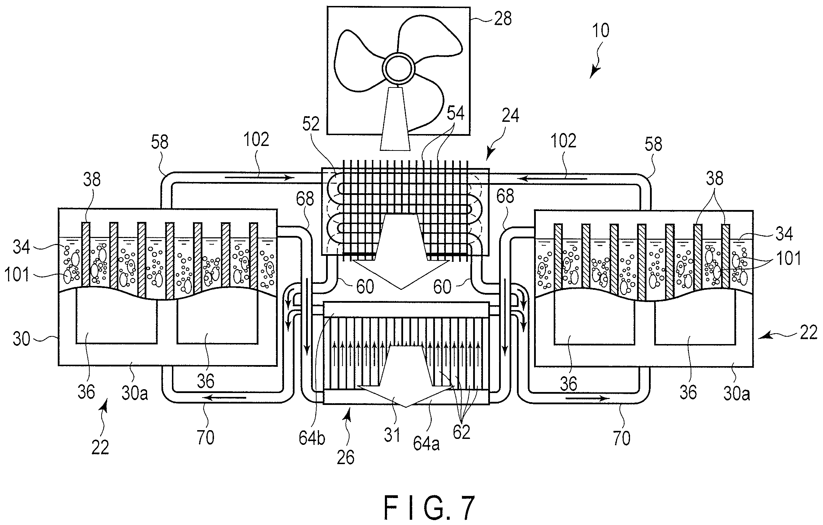

FIG. 7 shows a natural circulation type cooling apparatus 10 according to a second embodiment.

As shown in FIG. 7, according to the second embodiment, the natural circulation type cooling apparatus 10 is configured to adapt to a case of cooling a plurality of semiconductor devices 36. Specifically, the cooling apparatus 10 includes two heat receivers 22, and the heat receivers 22 are juxtaposed on the same plane. Semiconductor devices 36 are mounted on the heat receiving surface 30a of each heat receiver 22. The heat receiving surfaces 30a of the two heat receivers 22 are located on the same plane. The condenser 24 and radiator 26 are disposed between the two heat receivers 22, and are located on substantially the same plane as the heat receiving surfaces 30a of the heat receivers 22. Each heat receiver 22 is connected to the condenser 24 and radiator 26 via the vapor conduit 58 and coolant circulation conduit. Two outlets of the condenser 24 are connected to coolant circulation conduits via condensed liquid conduits 60. Specifically, one condenser 24 and one radiator 26 are provided for the two heat receivers 22. In addition, the condenser 24 and radiator 26 are handled as one body, and the air blower 28 is disposed on the outside, immediately near them, or via an air duct.

In the present embodiment, although not illustrated, such a configuration may be adopted that a plurality of cooling apparatuses 10 are disposed in parallel, these cooling apparatuses 10 are assembled as one module, and the air blower 28 is disposed on the outside thereof.

In the meantime, the other structure of the cooling apparatus and the structure of each structural element are identical to those in the above-described first embodiment.

According to the cooling apparatus 10 with the above-described structure, the two heat receivers 22 are disposed on both sides of the condenser 24 and radiator 26. Thereby, the vapors 102, which are fed out of the heat receivers 22, come together from the two vapor conduits 58 and flow in the condenser 24. In addition, the high-temperature coolants 34, which flow out of the heat receivers 22, flow in the radiator 26 via two condensed liquid conduits 60, and are subjected to heat exchange by the radiator 26. Thereafter, the coolant 34 in the subcool state branches into two, and the branched coolants 34 return to the heat receivers 22 via coolant circulation conduits 70, thus performing a circulation loop operation.

In addition, by disposing the plural cooling apparatuses 10 in parallel, the condenser 24 and radiator 26, which are disposed at the central part, can be forcibly air-cooled in the state in which the condenser 24 and radiator 26 are integrated as one body. In this case, control is executed by varying the output of the air blower 28 in accordance with the magnitude in amount of radiation heat. The other operations are the same as in the first embodiment.

According to the cooling apparatus 10 of the second embodiment, one condenser 24 and one radiator 26 are disposed for two heat receivers 22, and thereby an efficient and good radiation capability can be exhibited. In addition, the volume of the apparatus, that is, the space for mounting, relative to the radiation capability of the cooling apparatus, can be reduced. Furthermore, by disposing the plural cooling apparatuses in parallel and blowing the cooling air 31 by the air blower 28, the cooling efficiency of the cooling apparatuses, relative to the number of semiconductor devices 36, can be improved, and the size and cost of the cooling apparatus can be reduced. Besides, in the second embodiment, too, the same advantageous effects as with the above-described first embodiment can be obtained.

### (Third Embodiment)

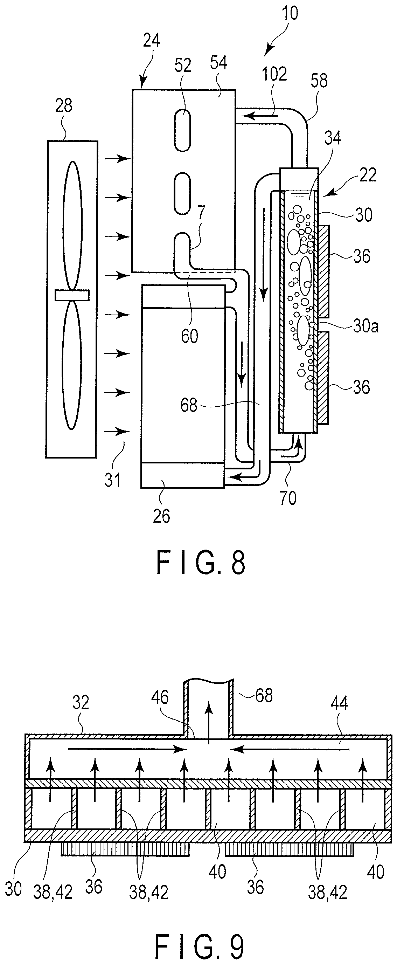

FIG. 8 is a side view which illustrates a natural circulation type cooling apparatus according to a third embodiment, and FIG. 9 is a cross-sectional view showing a structure of an upper part of a heat receiver.

According to the third embodiment, the condenser 24 and radiator 26 of the cooling apparatus 10 are disposed on the rear side of the heat receiver 22, the condenser 24 is disposed on the upper side, and the radiator 26 is disposed under the condenser 24. The air blower 28 for cooling the condenser 24 and radiator 26 is disposed to be opposed to the condenser 24 and radiator 26, and the air blower 28 air-cools the condenser 24 and radiator 26 as one body. Although not illustrated, such a configuration may be adopted that the condenser 24 and radiator 26 are laterally arranged in parallel, relative to the heat receiving surface 30a of the heat receiver 22 on which the semiconductor devices 36 are mounted, and the condensed liquid, which flows out of the condenser 24, directly flows down into the coolant circulation conduit 70. In this case, in order to prevent the subcool coolant 34, which flows out of the radiator 26, from flowing back to the condenser 24, a check vale may be disposed in the coolant circulation conduit 70.

In the meantime, the other structure of the cooling apparatus and the structure of each structural element are identical to those in the above-described first embodiment.

According to the cooling apparatus 10 with the above-described structure, the vapor generated by the heat receiver 22 and the high-temperature gas/liquid two-phase coolant 34 are fed out, respectively, to the condenser 24 and radiator 26 which are disposed on the rear side of the heat receiver 22. In this case, as shown in FIG. 9, such a configuration is adopted that when the high-temperature gas/liquid two-phase coolant 34, which has flowed out of the upper opening of the heat receiver 22, flows from the containing chambers 40 which are partitioned by the partition plates 38, the coolant 34 flows only a sub-flow passage 44 which faces an opposite surface to the heat receiving surface 30a to which the semiconductor devices 36 are attached. Thus, the outflow coolant 34 can easily be caused to flow into the radiator 26 via the coolant conduit 68.

The air blower 28 for air-cooling the condenser 24 and radiator 26 as one body is disposed on the rear side of the condenser 24 and radiator 26. The cooling air 31 is blown not only to the condenser 24 and radiator 26, but also to that surface of the heat receiver 22, which is opposite to the heat receiving surface 30a to which the semiconductor devices 36 are attached. The operations of the other elements are the same as in the first embodiment.

According to the cooling apparatus 10 with the above-described structure, the condenser 24 and radiator 26 are disposed on the rear side of the heat receiver 22. Thereby, the size of the apparatus in the horizontal direction, relative to the heat receiving surface 30a for semiconductor devices 36 of the heat receiver 22, can be reduced. In addition, by making the baffle plates 42 project from the liquid level in the heat receiver 22, the high-temperature gas/liquid two-phase coolant 34 is prevented from flowing back to the heat receiver 22, and can be fed out to the radiator 26 via the coolant conduit 68. Thus, since baffle plates, which are provided at the upper part of the heat receiver 22, are needless, the local pressure loss within the apparatus can be reduced, and the circulation efficiency of the coolant 34 can be improved. Therefore, the apparatus, as a whole, can maintain a desired radiation capability, and can suppress an increase in pressure within the apparatus. Besides, in the third embodiment, too, the same advantageous effects as with the above-described first embodiment can be obtained.

### (Fourth Embodiment)

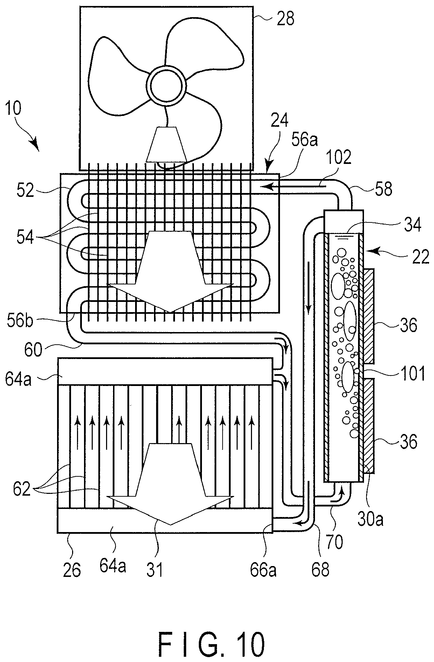

FIG. 10 schematically illustrates a natural circulation type cooling apparatus according to a fourth embodiment. As shown in FIG. 10, in a cooling apparatus 10 according to the fourth embodiment, the condenser 24 and radiator 26 are disposed on the rear side of the heat receiver 22, and the condenser 24 is disposed at the upper part and the radiator 26 is disposed at the lower part. The condenser 24 and radiator 26 are provided on a plane which is perpendicular to the heat receiver 22. The air blower 28 is disposed to be opposed to the condenser 24 and radiator 26 on the rear side of the heat receiver 22, so that cooling air may flow through both the condenser 24 and radiator 26. In this case, a plurality of cooling apparatuses 10 may be arranged in parallel, so that each individual condenser 24 and radiator 26 may be air-cooled as one body by one air blower 28, and the plural individual condensers 24 and radiators 26 may be air-cooled batchwise at the same time.

In the meantime, the other structure of the cooling apparatus and the structure of each structural element are identical to those in the above-described first embodiment.

According to the cooling apparatus 10 with the above-described structure, the condenser 24 and radiator 26 are air-cooled as one body, and the cooling air 31 by the air blower 28 flows through the condenser 24 and radiator 26, and flows in a plane direction which is parallel to the rear surface of the heat receiver 22 and to the heat receiving surface 30a to which the semiconductor devices 36 are attached. In the case where plural cooling apparatuses 10 are arranged in parallel, the cooling air 31 flows through each condenser 24 and radiator 26.

According to the above-described structure, the same advantageous effects as with the above-described third embodiment can be obtained, and the cooling air 31 can be flown to the heat receiver 22 from the lateral surface side. Thus, many similar cooling apparatuses can easily be arranged in parallel on this lateral surface side. In addition, since may cooling apparatuses can be cooled batchwise by one air blower 28, the size and weight of the entire apparatus can be reduced. Besides, the same advantageous effects as with the first embodiment can be obtained.

### (Fifth Embodiment)

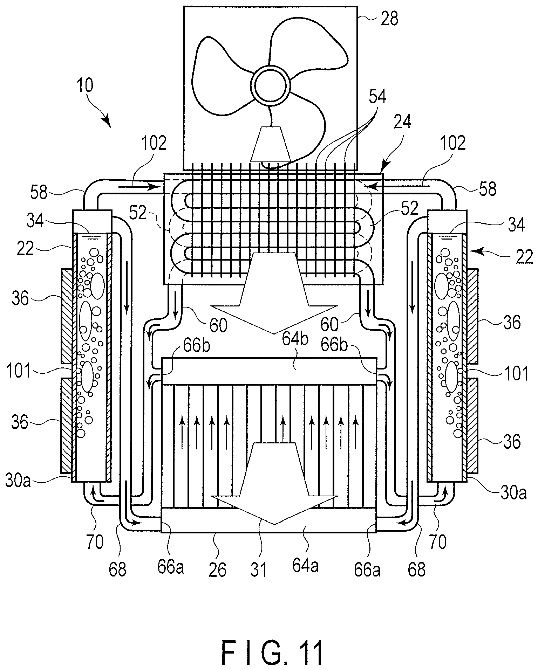

FIG. 11 schematically illustrates a natural circulation type cooling apparatus according to a fifth embodiment. As shown in FIG. 11, a cooling apparatus 10 according to the fifth embodiment includes two heat receivers 22 which are disposed to be opposed to each other, and a condenser 24 and a radiator 26 which are provided between the heat receivers 22, that is, on the rear sides of both heat receivers 22. The condenser 24 and radiator 26 are provided on a plane which is perpendicular to the heat receivers 22, and the condenser is 24 is disposed at the upper part and the radiator 26 is disposed at the lower part. In the heat receiver 22, no semiconductor device 36 is mounted on that surface of the heat receiver 22, which is located on the side facing the condenser 24 and radiator 26, that is, on the rear surface of the heat receiver 22. Semiconductor devices 36 are mounted on only the heat receiving surface 30a on the opposite side. The same applies to the structure of the other heat receiver 22. The air blower 28 is disposed to be opposed to the condenser 24 and radiator 26.

In the case where many semiconductor devices 36 are mounted and there are restrictions on disposition in the vertical direction, such a configuration is adopted that plural condensers 24 and radiators 26 are disposed in parallel in the horizontal direction, the air blower 28 is disposed on the lateral side, and the plural condensers 24 and radiators 26 are air-cooled as one body. In the case of the same condition as above and in the case where there are restrictions on disposition in the horizontal direction, such a configuration may be adopted that plural condensers 24 and radiators 26 are disposed in parallel in the vertical direction and are air-cooled as one body.

In each of the many cooling apparatuses 10 which are arranged in parallel as described above, vapors 102, which are generated from two heat receivers 22, are condensed into liquid in the condenser 24 and the liquid flows down to the inlets of the heat receivers 22. In addition, the coolant 34, which has become a high-temperature gas/liquid two-phase fluid in the heat receivers 22, is fed out to the inlet of radiator 26 via coolant conduits 68, and is subjected to heat exchange in the radiator. The coolant, which has transitioned into a subcool state by the lowering in temperature, flows back to both heat receivers 22. In the many cooling apparatuses that are arranged in parallel, the air blower 28 is disposed and heat exchange with outside air is performed by forced air-cooling. In the meantime, when there are restrictions on disposition in the vertical direction, many apparatuses are arranged in the horizontal direction, the air blower 28 is disposed on the lateral side and caused to blow air, and exhaust air is let to escape to the outside of the lateral parts of the apparatuses.

According to the cooling apparatus 10 of the fifth embodiment, the condenser 24 and radiator 26 are disposed on the rear sides of the two heat receivers 22, that is, the condenser 24 and radiator 26 are interposed between the two heat receivers 22. Thereby, the apparatus size in the horizontal direction can be reduced. In this structure, even in the case where there are restrictions on disposition of the apparatus, many apparatuses may be disposed in parallel in the horizontal direction or vertical direction, and the degree of freedom of design can be enhanced, relative to the increase in number of semiconductor devices. In addition, by disposing the air blower 28 on the lateral surface side or bottom surface side of the condenser 24 and radiator 26, the degree of freedom of disposition of the external air blower can also be enhanced.

In the above structure, not only the condenser 24 and radiator 26 can be cooled, but also air can be blown to the heat receivers 22. Thus, the temperature level in the cooling apparatus can be lowered, and the tolerable temperature of semiconductor devices can further be lowered. Moreover, by setting the coolant 34 in the heat receiver 22 in the subcool state, the heat-removal limit value can also be increased. Besides, in the fifth embodiment, too, the same advantageous effects as with the first embodiment can be obtained.

### (Sixth Embodiment)

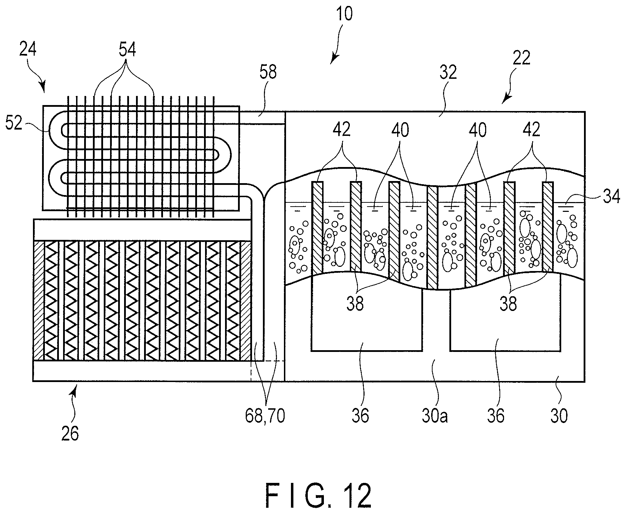

FIG. 12 schematically illustrates a natural circulation type cooling apparatus according to a sixth embodiment. As shown in FIG. 12, a cooling apparatus 10 according to the sixth embodiment includes a heat receiver 22, a condenser 24 and a radiator 26, which are provided on the same plane. These components are disposed closer to each other and are constructed as a unit. In the sixth embodiment, the other structure of the cooling apparatus and the structure of each structural element are identical to those in the above-described first embodiment.

According to the above structure, the same advantageous effects as with the above-described first embodiment can be obtained, and the size and weight of the apparatus can be reduced by constructing the apparatus as a single unit.

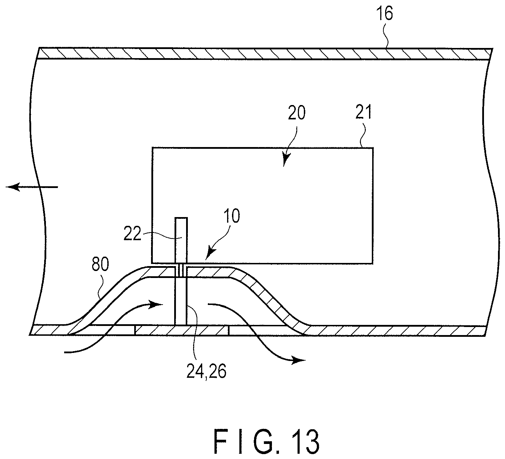

FIG. 13 schematically illustrates a railway vehicle in which a natural circulation type cooling apparatus according to a seventh embodiment is mounted. According to this embodiment, a heat receiver 22 of a cooling apparatus 10 is disposed within a housing 21 of a power converter 20 which is provided under the floor of the vehicle body 16, and a plurality of semiconductor devices, which are exothermic bodies, are mounted on the heat receiving surface of the heat receiver 22. A condenser 24 and a radiator 26 of the cooling apparatus 10 are disposed on a horizontally lateral side of the heat receiver 22, on the outside of the housing 21. The vehicle body 16 includes an air duct 80 for guiding a traveling wind caused by traveling, and the condenser 24 and radiator 26 are disposed in the air duct 80. Thereby, the condenser 24 and radiator 26 are cooled as one body by the traveling wind flowing in the air duct 80. In this case, the air blower 28 may be dispensed with.

The other structure of the cooling apparatus 10 is identical to that of the above-described first embodiment. According to the cooling apparatus having this structure, the same advantageous effects as with the first embodiment can be obtained. Moreover, the air blower can be dispensed with, and the manufacturing cost and the space for installation can be reduced.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions. The accompanying claims and their equivalents are intended to cover such forms or modifications as would fall within the scope of the inventions, as defined by the claims.

The exothermic body, which is a target of cooling of the cooling apparatus, is not limited to a semiconductor device of a power converter, and may be other exothermic bodies. The material, of which the heat receiver and heat receiving surface are formed, is not limited to the examples in the above-described embodiment, and may be selected from various materials.

## Claims

1. A natural circulation type cooling apparatus comprising:
a heat receiver (22) comprising a heat receiving surface (30a) on which an exothermic body (36) is mounted, and containing therein a coolant (34) in a liquid phase;
a condenser (24) provided on a horizontally lateral side of the heat receiver, and configured to condense a vapor which is generated by the heat receiver;
a radiator (26) disposed on a horizontally lateral side of the heat receiver,
and configured to cool the coolant which is fed from the heat receiver and is heated;
a vapor conduit (58) configured to feed the vapor of the coolant, which is generated by the heat receiver, to an inlet of the condenser;
a condensed liquid conduit (60) configured to feed the coolant, which is condensed, from an outlet of the condenser to a coolant inlet of the heat receiver;
a coolant conduit (68) configured to feed the coolant, which is heated in the heat receiver, to an inlet of the radiator; and
a coolant circulation conduit (70) configured to feed the coolant, which is cooled in the radiator, from an outlet of the radiator to the coolant inlet of the heat receiver
**characterized in that** the radiator (26) is disposed on a vertically downward side of the condenser.

2. The natural circulation type cooling apparatus of claim 1, **characterized in that** the heat receiver (22) comprises:
a container body (30) comprising the heat receiving surface (30a) and an upper opening, and containing the coolant;
an upper container (32) configured to cover the upper opening of the container body;
a plurality of partition plates (38) provided at intervals within the container body, and configured to partition an inside of the container body into a plurality of containing chambers (40) which contain the coolant, respectively;
a plurality of baffle plates (42) extending upward from the upper opening of the container body (30), beyond a liquid level of the coolant, and configured to restrict inflow of the coolant from each of the containing chambers (40) into another of the containing chambers (40);
a vapor outlet (46) formed in the upper container (32) and communicating with the plurality of containing chambers via a space in the upper container;
a coolant inlet (50) formed in a lower part of the container body (30) and communicating with the plurality of containing chambers (40);
a coolant outlet (48) formed in the upper container; and
a sub-flow passage (44) defined by the upper container and configured to guide the coolant, which flows out of the containing chambers, to the coolant outlet.

3. The natural circulation type cooling apparatus of claim 2, **characterized in that** each of the partition plates (38) comprises an upper end portion which extends upward beyond the liquid level of the coolant (34) and constitutes the baffle plate (42).

4. The natural circulation type cooling apparatus of any one of claim 1 to claim 3, **characterized in that** the condensed liquid conduit (60) is connected between the outlet of the condenser (24) and an intermediate portion of the coolant circulation conduit (70).

5. The natural circulation type cooling apparatus of claim 1, **characterized in that** the radiator (26) comprises an inflow portion which includes the inlet of the coolant, an outflow portion which includes the outlet of the coolant and is located on a vertically upward side of the inlet portion, and a plurality of radiation tubes which extend between the inflow portion and the outflow portion and through which the heated coolant flows.

6. The natural circulation type cooling apparatus of claim 1, **characterized by** further comprising an air blower (28) configured to blow cooling air to the condenser and the radiator.

7. The natural circulation type cooling apparatus of claim 6, **characterized by** further comprising a duct (72) provided between the condenser (24) and the radiator (26), on the one hand, and the air blower (28), on the other hand, and configured to guide the cooling air from the air blower to the condenser and the radiator.

8. The natural circulation type cooling apparatus of claim 1, **characterized by** further comprising another heat receiver (22) including a heat receiving surface (30a) on which an exothermic body is mounted, and containing a coolant,
wherein the two heat receivers (22) are arranged such that the heat receiving surfaces thereof are located in a common plane, and the condenser (24) and the radiator (26) are disposed between the two heat receivers and are disposed at lateral side parts of the heat receivers, relative to the common plane as the heat receiving surfaces.

9. The natural circulation type cooling apparatus of claim 1, **characterized in that** the heat receiving surface (30a) is formed on one of surfaces of the heat receiver (22), the condenser (24) is arranged at an upper part on a rear side of the heat receiver, which is opposite to the heat receiving surface, and the radiator (26) is arranged at a lower part on the rear side.

10. The natural circulation type cooling apparatus of claim 1, **characterized in that** the heat receiving surface (30a) is formed on one of surfaces of the heat receiver (22), the condenser (24) is arranged at an upper part on a rear side of the heat receiver, which is opposite to the heat receiving surface, the radiator (26) is arranged at a lower part on the rear side, and the condenser and the radiator are provided on a plane which is perpendicular to the heat receiving surface of the heat receiver.

11. The natural circulation type cooling apparatus of claim 1, **characterized by** further comprising another heat receiver (22) including a heat receiving surface (30a) on which an exothermic body is mounted, and containing a coolant,
wherein the two heat receivers (22) are arranged such that rear surfaces thereof, which are opposite to the heat receiving surfaces, are opposed to each other, the condenser (24) is arranged at an upper part between the two heat receivers, the radiator (26) is arranged at a lower part between the two heat receivers, and the condenser and the radiator are arranged on a plane which is perpendicular to the heat receiving surfaces of the heat receivers.

## Patentansprüche

1. Kühlgerät mit natürlicher Zirkulation, das Folgendes aufweist:
einen Wärmeempfänger (22), der eine wärmeaufnehmende Oberfläche (30a) aufweist, an der ein exothermer Körper (36) befestigt ist, und wobei darin ein Kühlmittel (34) in einer Flüssigphase enthalten ist;
einen Kondensator (24), der auf einer horizontal lateralen Seite des Wärmeempfängers vorgesehen ist, und dazu ausgelegt ist, einen Dampf, der von dem Wärmeempfänger erzeugt wird, zu kondensieren;
einen Kühlkörper (26), der auf einer horizontal lateralen Seite des Wärmeempfängers angeordnet ist, und dazu ausgelegt ist, das Kühlmittel, das von dem Wärmeempfänger zugeführt wird und erwärmt ist, zu kühlen;
eine Dampfleitung (58), die dazu ausgelegt ist, den Dampf des Kühlmittels, der von dem Wärmeempfänger erzeugt wird, zu einem Einlass des Kondensators zu leiten;
eine Leitung (60) für kondensierte Flüssigkeit, die dazu ausgelegt ist, das Kühlmittel, das kondensiert ist, von einem Auslass des Kondensators zu einem Kühlmitteleinlass des Wärmeempfängers zu leiten;
eine Kühlmittelleitung (68), die dazu ausgelegt ist, das Kühlmittel, das in dem Wärmeempfänger erwärmt wird, zu einem Einlass des Kühlkörpers zu leiten; und
eine Kühlmittelzirkulationsleitung (70), die dazu ausgelegt ist, das Kühlmittel, das in dem Kühlkörper gekühlt wird, von einem Auslass des Kühlkörpers zu dem Kühlmitteleinlass des Wärmeempfängers zu leiten;
**dadurch gekennzeichnet, dass** der Kühlkörper (26) an einer vertikalen Abwärtsseite des Kondensators angeordnet ist.

2. Kühlgerät mit natürlicher Zirkulation nach Anspruch 1, **dadurch gekennzeichnet, dass** der Wärmeempfänger (22) Folgendes aufweist:
einen Behälterkörper (30), der die wärmeaufnehmende Oberfläche (30a) und eine obere Öffnung aufweist und das Kühlmittel enthält;
einen oberen Behälter (32), der dazu ausgelegt ist, die obere Öffnung des Behälterkörpers abzudecken;
eine Vielzahl an Trennplatten (38), die in Abständen innerhalb des Behälterkörpers vorgesehen sind, und dazu ausgelegt sind, einen Innenraum des Behälterkörpers in eine Vielzahl an Behälterkammern (40), die jeweils das Kühlmittel enthalten, zu unterteilen;
eine Vielzahl an Prallplatten (42), die sich von der oberen Öffnung des Behälterkörpers (30) über eine Flüssigkeitsgrenze des Kühlmittels hinaus nach oben erstrecken und dazu ausgelegt sind, Eintritt des Kühlmittels von jeder der Behälterkammern (40) in eine andere der Behälterkammern (40) zu beschränken;
einen Dampfauslass (46), der in dem oberen Behälter (32) gebildet ist und über einen Raum in dem oberen Behälter mit der Vielzahl an Behälterkammern in Verbindung steht;
einen Kühlmitteleinlass (50), der in einem unteren Abschnitt des Behälterkörpers (30) gebildet ist und mit der Vielzahl an Behälterkammern (40) in Verbindung steht;
einen Kühlmittelauslass (48), der in dem oberen Behälter gebildet ist; und
einen Teilstromdurchfluss (44), der von dem oberen Behälter definiert wird und dazu ausgelegt ist, das Kühlmittel, das aus den Behälterkammern ausströmt, zu dem Kühlmittelauslass zu leiten.

3. Kühlgerät mit natürlicher Zirkulation nach Anspruch 2, **dadurch gekennzeichnet, dass** jede der Trennplatten (38) einen oberen Endabschnitt aufweist, der sich über die Flüssigkeitsgrenze des Kühlmittels (34) hinaus nach oben erstreckt und die Prallplatte (42) darstellt.

4. Kühlgerät mit natürlicher Zirkulation nach einem der Ansprüche 1 bis 3, **dadurch gekennzeichnet, dass** die Leitung (60) für kondensierte Flüssigkeit zwischen dem Auslass des Kondensators (24) und einem Zwischenabschnitt der Kühlmittelzirkulationsleitung (70) verbunden ist.

5. Kühlgerät mit natürlicher Zirkulation nach Anspruch 1, **dadurch gekennzeichnet, dass** der Kühlkörper (26) einen Eintrittsabschnitt, der den Einlass des Kühlmittels aufweist, einen Austrittsabschnitt, der den Auslass des Kühlmittels aufweist und auf einer vertikalen Aufwärtsseite des Einlassabschnitts angeordnet ist, und eine Vielzahl an Heizrohren, die sich zwischen dem Eintrittsabschnitt und dem Austrittsabschnitt erstrecken und durch die das erwärmte Kühlmittel fließt, aufweist.

6. Kühlgerät mit natürlicher Zirkulation nach Anspruch 1, **dadurch gekennzeichnet, dass** es ferner ein Luftgebläse (28) aufweist, das dazu ausgelegt ist, Kühlluft zu dem Kondensator und dem Kühlkörper zu blasen.

7. Kühlgerät mit natürlicher Zirkulation nach Anspruch 6, **dadurch gekennzeichnet, dass** es ferner einen Kanal (72), der zwischen dem Kondensator (24) und dem Kühlkörper (26) vorgesehen ist, auf der einen Seite, und das Luftgebläse (28) auf der anderen Seite aufweist, und dazu ausgelegt ist, die Kühlluft von dem Luftgebläse zu dem Kondensator und dem Kühlkörper zu leiten.

8. Kühlgerät mit natürlicher Zirkulation nach Anspruch 1, **dadurch gekennzeichnet, dass** es ferner einen weiteren Wärmeempfänger (22) aufweist, der eine wärmeaufnehmende Oberfläche (30a) aufweist, an der ein exothermer Körper befestigt ist, und ein Kühlmittel enthält,
wobei die zwei Wärmeempfänger (22) derart angeordnet sind, dass sich die wärmeaufnehmenden Oberflächen davon auf einer gemeinsamen Ebene befinden, und der Kondensator (24) und der Kühlkörper (26) sind zwischen den zwei Wärmeempfängern angeordnet und sind an lateralen Seitenabschnitten der Wärmeempfänger angeordnet, in Bezug auf die gemeinsame Ebene als die wärmeaufnehmenden Oberflächen.

9. Kühlgerät mit natürlicher Zirkulation nach Anspruch 1, **dadurch gekennzeichnet, dass** die wärmeaufnehmende Oberfläche (30a) auf einer von Oberflächen des Wärmeempfängers (22) gebildet ist, wobei der Kondensator (24) an einem oberen Abschnitt auf einer hinteren Seite des Wärmeempfängers angeordnet ist, die sich gegenüberliegend der wärmeaufnehmenden Oberfläche befindet, und der Kühlkörper (26) ist an einem unteren Abschnitt auf der hinteren Seite angeordnet.

10. Kühlgerät mit natürlicher Zirkulation nach Anspruch 1, **dadurch gekennzeichnet, dass** die wärmeaufnehmende Oberfläche (30a) auf einer von Oberflächen des Wärmeempfängers (22) gebildet ist, wobei der Kondensator (24) an einem oberen Abschnitt auf einer hinteren Seite des Wärmeempfängers angeordnet ist, die sich gegenüberliegend der wärmeaufnehmenden Oberfläche befindet, wobei der Kühlkörper (26) an einem unteren Abschnitt auf der hinteren Seite angeordnet ist, und der Kondensator und der Kühlkörper auf einer Ebene angeordnet sind, die senkrecht zu der wärmeaufnehmenden Oberfläche des Wärmeempfängers ist.

11. Kühlgerät mit natürlicher Zirkulation nach Anspruch 1, **dadurch gekennzeichnet, dass** es ferner einen weiteren Wärmeempfänger (22) aufweist, der eine wärmeaufnehmende Oberfläche (30a), auf der ein exothermer Körper befestigt ist, aufweist, und ein Kühlmittel enthält,
wobei die zwei Wärmeempfänger (22) derart angeordnet sind, dass hintere Oberflächen davon, die sich gegenüberliegend der wärmeaufnehmenden Oberflächen befinden, einander gegenüberliegen, wobei der Kondensator (24) an einem oberen Abschnitt zwischen den zwei Wärmeempfängern angeordnet ist, wobei der Kühlkörper (26) an einem unteren Abschnitt zwischen den zwei Wärmeempfängern angeordnet ist, und der Kondensator und der Kühlkörper sind auf einer Ebene angeordnet, die senkrecht zu den wärmeaufnehmenden Oberflächen der Wärmeempfänger ist.

## Revendications

1. Dispositif de refroidissement du type à circulation naturelle, comprenant :
un récepteur de chaleur (22) comprenant une surface de réception de chaleur (30a) sur laquelle est monté un corps exothermique (36), et contenant un fluide de refroidissement (34) dans une phase liquide ;
un condensateur (24) disposé sur un côté horizontalement latéral du récepteur de chaleur, et configuré pour condenser une vapeur générée par le récepteur de chaleur ;
un radiateur (26) disposé sur un côté horizontalement latéral du récepteur de chaleur, et configuré pour refroidir le fluide de refroidissement alimenté depuis le récepteur de chaleur et chauffé ;
un conduit de vapeur (58) configuré pour alimenter la vapeur du fluide de refroidissement, laquelle est générée par le récepteur de chaleur, vers une entrée du condensateur ;
un conduit de liquide condensé (60) configuré pour alimenter le fluide de refroidissement, lequel est condensé, à partir d'une sortie du condensateur vers une entrée de fluide de refroidissement du récepteur de chaleur ;
un conduit de fluide de refroidissement (68) configuré pour alimenter le fluide de refroidissement, lequel est chauffé dans le récepteur de chaleur, vers une entrée du radiateur ; et
un conduit de circulation de fluide de refroidissement (70) configuré pour alimenter le fluide de refroidissement, lequel est refroidi dans le radiateur, à partir d'une sortie du radiateur vers l'entrée de fluide de refroidissement du récepteur de chaleur,
**caractérisé en ce que** le radiateur (26) est disposé sur un côté du condensateur s'étendant verticalement vers le bas.

2. Dispositif de refroidissement du type à circulation naturelle selon la revendication 1, **caractérisé en ce que** le récepteur de chaleur (22) comprend :
un corps de récipient (30) comprenant la surface de réception de chaleur (30a) et une ouverture supérieure, et contenant le fluide de refroidissement ;
un récipient supérieur (32) configuré pour recouvrir l'ouverture supérieure du corps de récipient ;
une pluralité de plaques de division (38) disposées à des intervalles dans le corps de récipient, et configurées pour diviser un intérieur du corps de récipient en une pluralité de chambres de confinement (40) contenant le fluide de refroidissement, respectivement ;
une pluralité de plaques de déviation (42) s'étendant vers le haut à partir de l'ouverture supérieure du corps de récipient (30), au-delà d'un niveau de liquide du fluide de refroidissement, et configurées pour restreindre l'écoulement du fluide de refroidissement à partir de chacune des chambres de confinement (40) dans une autre des chambres de confinement (40) ;
une sortie de vapeur (46) formée dans le récipient supérieur (32) et communiquant avec la pluralité de chambres de confinement par le biais d'un espace dans le récipient supérieur ;
une entrée de fluide de refroidissement (50) formée dans une partie inférieure du corps de récipient (30) et communiquant avec la pluralité de chambres de confinement (40) ;
une sortie de fluide de refroidissement (48) définie par le récipient supérieur ; et
un passage de flux partiel (44) défini par le récipient supérieur et configuré pour guider le fluide de refroidissement, lequel sort des chambres de confinement, vers la sortie de fluide de refroidissement.

3. Dispositif de refroidissement du type à circulation naturelle selon la revendication 2, **caractérisé en ce que** chacune des plaques de division (38) comprend une partie d'extrémité supérieure s'étendant vers le haut au-delà du niveau de liquide du fluide de refroidissement (34) et constituant la plaque de déviation (42).

4. Dispositif de refroidissement du type à circulation naturelle selon l'une quelconque des revendications 1 à 3, **caractérisé en ce que** le conduit de liquide condensé (60) est raccordé entre la sortie du condensateur (24) et une partie intermédiaire du conduit de circulation de fluide de refroidissement (70).

5. Dispositif de refroidissement du type à circulation naturelle selon la revendication 1, **caractérisé en ce que** le radiateur (26) comprend une partie d'admission incluant l'entrée du fluide de refroidissement, une partie d'évacuation incluant la sortie du fluide de refroidissement et située sur un côté verticalement supérieur de la partie d'entrée, et une pluralité de tubes de rayonnement s'étendant entre la partie d'admission et la partie d'évacuation et à travers lesquels s'écoule le fluide de refroidissement chauffé.

6. Dispositif de refroidissement du type à circulation naturelle selon la revendication 1, **caractérisé en ce qu'**il comprend en outre une soufflerie d'air (28) configurée pour souffler de l'air de refroidissement vers le condensateur et le radiateur.

7. Dispositif de refroidissement du type à circulation naturelle selon la revendication 6, **caractérisé en ce qu'**il comprend en outre une conduite (72) disposée entre le condensateur (24) et le radiateur (26), d'une part, et la soufflerie d'air (28) d'autre part, et configurée pour guider l'air de refroidissement depuis la soufflerie d'air vers le condensateur et le radiateur.

8. Dispositif de refroidissement du type à circulation naturelle selon la revendication 1, **caractérisé en ce qu'**il comprend en outre un autre récepteur de chaleur (22) incluant une surface de réception de chaleur (30a) sur laquelle est monté un corps exothermique, et contenant un fluide de refroidissement,
dans lequel les deux récepteurs de chaleur (22) sont agencés de telle façon que les surfaces de réception de chaleur de ceux-ci se trouvent dans un plan commun, et le condensateur (24) et le radiateur (26) sont disposés entre les deux récepteurs de chaleur et sont disposés sur des parties de côté latéral des récepteurs de chaleur, par rapport au plan commun en tant que surfaces de réception de chaleur.

9. Dispositif de refroidissement du type à circulation naturelle selon la revendication 1, **caractérisé en ce que** la surface de réception de chaleur (30a) est formée sur l'une des surfaces du récepteur de chaleur (22), le condensateur (24) est agencé au niveau d'une partie supérieure sur un côté arrière du récepteur de chaleur, lequel est opposé à la surface de réception de chaleur, et le radiateur (26) est agencé au niveau d'une partie inférieure sur le côté arrière.

10. Dispositif de refroidissement du type à circulation naturelle selon la revendication 1, **caractérisé en ce que** la surface de réception de chaleur (30a) est formée sur l'une des surfaces du récepteur de chaleur (22), le condensateur (24) est agencé au niveau d'une partie supérieure sur un côté arrière du récepteur de chaleur, lequel est opposé à la surface de réception de chaleur, le radiateur (26) est agencé au niveau d'une partie inférieure sur le côté arrière, et le condensateur et le radiateur sont disposés sur un plan perpendiculaire à la surface de réception de chaleur du récepteur de chaleur.

11. Dispositif de refroidissement du type à circulation naturelle selon la revendication 1, **caractérisé en ce qu'**il comprend en outre un autre récepteur de chaleur (22) incluant une surface de réception de chaleur (30a) sur laquelle est monté un corps exothermique, et contenant un fluide de refroidissement,
dans lequel les deux récepteurs de chaleur (22) sont agencés de telle façon que les surfaces arrières de ceux-ci, lesquelles sont opposées aux surfaces de réception de chaleur, sont opposées l'une à l'autre, le condensateur (24) est agencé au niveau d'une partie supérieure entre les deux récepteurs de chaleur, et le radiateur (26) est agencé au niveau d'une partie inférieure entre les deux récepteurs de chaleur, et le condensateur et le radiateur sont agencés sur un plan perpendiculaire aux surfaces de réception de chaleur des récepteurs de chaleur.
